# EUROPEAN PATENT SPECIFICATION

(11) **EP 3 157 053 B1**
(45) Date of publication and mention of the grant of the patent: **30.12.2020**
(21) Application number: 16193536.6
(22) Date of filing: 12.10.2016
(51) Int. Cl.: H01L 23/36, H01L 23/538

(54) **POWER MODULE**
LEISTUNGSMODUL
MODULE D'ALIMENTATION

(30) Priority: 14.10.2015 SG 10201508520P
(43) Date of publication of application: 19.04.2017
(73) Proprietor: Delta Electronics Int'l (Singapore) Pte Ltd, 417939 05-04 Singapore (SG)
(72) Inventor: LAI, Yiu-Wai, 417939 05 04 Singapore (SG); CHEN, Da-Jung, 417939 05-04 Singapore (SG)
(74) Representative: 2K Patentanwälte Blasberg Kewitz & Reichel

(56) References cited:
- EP-A1- 2 244 288
- US-A1- 2010 078 783
- US-A1- 2013 020 694
- US-A1- 2015 255 380
- US-B1- 9 107 290

## Description

### FIELD OF THE INVENTION

The present invention relates to a power module, and more particularly to a power module with enhanced heat dissipating efficiency.

### BACKGROUND OF THE INVENTION

Recently, the general trends in designing power converters are toward high efficiency and high density. The high efficiency power converter can reduce the power loss and achieve the power-saving purpose. The high density power converter can reduce the overall volume of the electronic product and meet the requirements of small size and light weightiness.

Generally, a power converter comprises a bridge circuit for rectification. The bridge circuit comprises at least one high-voltage-side switching element and at least one low-voltage-side switching element. For example, a three-phase bridge circuit of a three-phase power converter comprises three high-voltage-side switching elements and three low-voltage-side switching elements. The high-voltage-side switching elements are connected with the corresponding low-voltage-side switching elements in series. Each of the high-voltage-side switching elements and the low-voltage-side switching elements comprises a semiconductor switch and a diode, which are connected with each other in parallel. For example, the semiconductor switch is an insulated-gate bipolar transistor (IGBT). By alternately turning on and turning off the semiconductor switch, the bridge circuit can rectify the input power. When the semiconductor switch is turned off, the diode allows the current to continuously flow.

A conventional method of fabricating the bridge circuit of the power converter will be illustrated as follows. Firstly, the semiconductor switches and the diodes of the high-voltage-side switching elements are attached on a first substrate by solder and then wire bonded, and the semiconductor switches and the diodes of the low-voltage-side switching elements are attached on a second substrate and then wire bonded. Then, the high-voltage-side switching elements and the low-voltage-side switching elements are disposed on a circuit board. Then, the semiconductor switches and the diodes of the high-voltage-side switching elements and the semiconductor switches and the diodes of the low-voltage-side switching elements are connected with each other and/or connected with an external component by a wire-bonded technology (e.g. through aluminum wires or copper wires).

However, the side of the circuit board for wire-bonding the high-voltage-side switching elements and the low-voltage-side switching elements cannot be equipped with any heat sink. Since the substrate is only able to dissipate away heat in a single direction, the heat dissipating efficiency is insufficient. Moreover, since the electronic components of the high-voltage-side switching elements and the low-voltage-side switching elements are attached on the corresponding substrates by solder, the conventional method of fabricating the bridge circuit is very complicated. Moreover, the long wires for connecting the high-voltage-side switching elements and the low-voltage-side switching elements by the wire-bonded technology may increase the parasitic inductance between the wires and the circuit board. Under this circumstance, the switching efficiency and the power conversion efficiency of the high-voltage-side switching elements and the low-voltage-side switching elements are adversely affected.
US 2010 078 783 A1 discloses a device including two mounting surfaces. One embodiment provides a power semiconductor chip and having a first electrode on a first surface and a second electrode on a second surface opposite to the first surface. A first external contact element and a second external contact element, are both electrically coupled to the first electrode of the semiconductor chip. A third external contact element and a fourth external contact element, both electrically coupled to the second electrode of the semiconductor chip. A first mounting surface is provided on which the first and third external contact elements are disposed. A second mounting surface is provided on which the second and fourth external contact elements are disposed.
US 2013 020 694 A1 discloses a double sided cooled power module package having a single phase leg topology includes two IGBT and two diode semiconductor dies. Each IGBT die is spaced apart from a diode semiconductor die, forming a switch unit. Two switch units are placed in a planar face-up and face-down configuration. A pair of DBC or other insulated metallic substrates is affixed to each side of the planar phase leg semiconductor dies to form a sandwich structure. Attachment layers are disposed on outer surfaces of the substrates and two heat exchangers are affixed to the substrates by rigid bond layers. The heat exchangers, made of copper or aluminum, have passages for carrying coolant. The power package is manufactured in a two-step assembly and heating process where direct bonds are formed for all bond layers by soldering, sintering, solid diffusion bonding or transient liquid diffusion bonding, with a specially designed jig and fixture.
US 2015 255 380 A1 discloses a package structure including an insulation layer, a first conductive layer, a second conductive layer, at least one electronic component, and at least one thermal conduction structure. At least one first conductive via and at least one second conductive via are formed in the insulation layer. The first conductive layer is disposed on a top surface of the insulation layer and contacted with said at least one first conductive via. The second conductive layer is disposed on a bottom surface of the insulation layer and contacted with the second conductive via. The electronic component is embedded within the insulation layer, and includes plural conducting terminals. The plural conducting terminal is electrically connected with the first conductive layer and the second conductive layer through said at least one first conductive via and said at least one second conductive via. Said at least one thermal conduction structure is embedded within the insulation layer.
US 9 107 290 B1 discloses a package structure including two insulation layers, three conductive layers, and two electronic components. The first and second conductive layers are disposed on a top surface and a bottom surface of the first insulation layer, respectively. The second insulation layer is disposed over the first conductive layer. The third conductive layer is disposed on a top surface of the second insulation layer. The first and second electronic components are embedded within the first and second insulation layers, respectively. The first conducting terminals of the first electronic component are electrically connected with the first conductive layer and the second conductive layer through at least one first conductive via and at least one second conductive via. The second conducting terminals of the second electronic component are electrically connected with the first conductive layer and/or electrically connected with the third conductive layer through at least one third conductive via.

Therefore, there is a need of providing an improved power module so as to overcome the above drawbacks.

### SUMMARY OF THE INVENTION

An object of the present invention provides a power module with semiconductor switches and diodes embedded within insulation layers. Consequently, a first sub-module and a second sub-module are formed as a high-voltage-side switching element and a low-voltage-side switching element of a bridge circuit. The first sub-module and the second sub-module are disposed on a first surface of a substrate. An electrode of the first sub-module and some electrodes of the second sub-module are electrically connected with corresponding conducting parts of a circuit board. A heat sink is disposed on a second surface of the substrate. Consequently the power module of the present invention has enhanced heat dissipating efficiency, simplified fabricating process, increased switching efficiency and increased power conversion efficiency.

In accordance with an aspect of the present invention, there is provided a power module. The power module includes a substrate, a first sub-module, a second sub-module, a conductive pin, a circuit board and a heat sink. The substrate comprises a first conductive layer disposed on a first surface and a second conductive layer disposed on a second surface opposite to the first surface. The first conductive layer comprises a plurality of conductive blocks, including a first conductive block, a second conductive block, a third conductive block and a fourth conductive block. The first sub-module is disposed on the first conductive layer, and the first sub-module comprises a first semiconductor switch and a first diode which is connected in parallel with the first semiconductor switch, wherein the first sub-module further comprises a first electrode, a second electrode, a third electrode and a fourth electrode and the third electrode is electrically connected with the third conductive block. The second sub-module is disposed on the first conductive layer, and the second sub-module comprises a second semiconductor switch and a second diode which is connected in parallel with the second semiconductor switch. The second semiconductor switch is electrically connected with the first semiconductor switch through the plurality of conductive blocks, wherein the second sub-module further comprises a fifth electrode, a sixth electrode and a seventh electrode, and the seventh electrode is electrically connected with the third conductive block. The conductive pin is disposed on the first conductive layer and electrically connected with at least one of the conductive blocks, wherein a first end of the conductive pin is electrically connected with the first conductive block. The circuit board is disposed on the conductive pin and electrically connected with the first semiconductor switch and the second semiconductor switch through the conductive pin. The heat sink is disposed on the second conductive layer, wherein the first sub-module further comprises a first thermal/electrical conduction structure and a first lead electrode, and the second sub-module further comprises a second thermal/electrical conduction structure and a second lead electrode, wherein the first thermal/electrical conduction structure is arranged between the first electrode and the first lead electrode and electrically connected with the first electrode and the first lead electrode, wherein the second thermal/electrical conduction structure is arranged between the sixth electrode and the second lead electrode, and electrically connected with the sixth electrode and the second lead electrode, wherein the first lead electrode is electrically connected with the first conductive block.

The above contents of the present invention will become more readily apparent to those ordinarily skilled in the art after reviewing the following detailed description and accompanying drawings, in which:

### BRIEF DESCRIPTION OF THE DRAWINGS

FIG. 1 is a schematic perspective view illustrating a power module according to an embodiment of the present invention;
FIG. 2 is a schematic circuit diagram illustrating a three-phase bridge circuit of a three-phase power converter with the power module of FIG. 1;
FIG. 3 is a schematic cross-sectional view illustrating an exemplary first sub-module of the power module of FIG. 1;
FIG. 4 is a schematic cross-sectional view illustrating an exemplary second sub-module of the power module of FIG. 1;
FIGS. 5A∼5D are schematic cross-sectional views illustrating the steps of packaging the power module 1 of FIG. 1;
FIG. 6 is a schematic cross-sectional view illustrating a power module according to a second embodiment of the present invention; and
FIG. 7 is a schematic cross-sectional view illustrating a power module according to a third embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

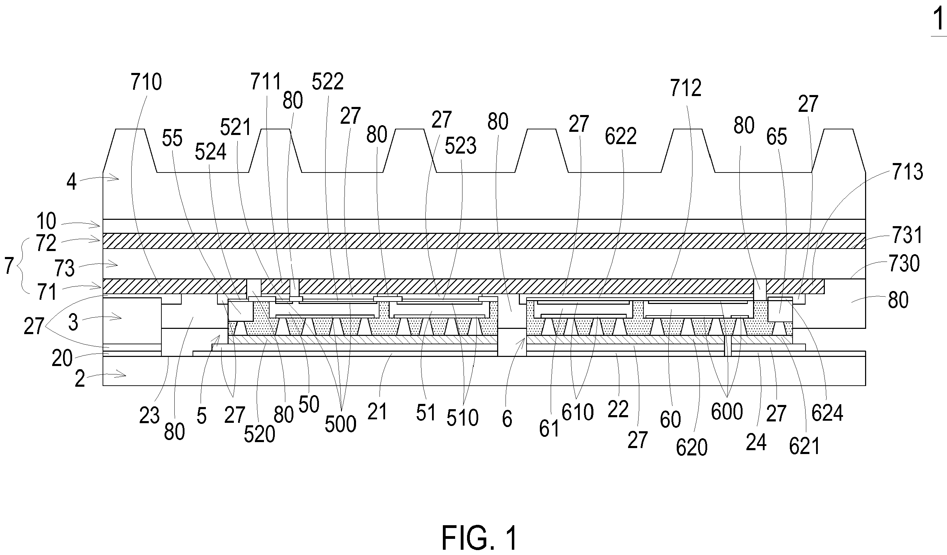

FIG. 1 is a schematic perspective view illustrating a power module according to an embodiment of the present invention. As shown in FIG. 1, the power module 1 comprises a circuit board 2, a conductive pin 3, a heat sink 4, a first sub-module 5, a second sub-module 6 and a substrate 7. The conductive pin 3 is an individual pin that can be soldered.

The first sub-module 5 comprises a first semiconductor switch 50, a first diode 51, a first electrode 520, a second electrode 521, a third electrode 522, a fourth electrode 523, a first thermal/electrical conduction structure 55 and a first lead electrode 524. The first electrode 520 is located at a first side of the first sub-module 5. The second electrode 521, the third electrode 522, the fourth electrode 523 and the first lead electrode 524 are located at a second side of the first sub-module 5. The first semiconductor switch 50 comprises plural first conducting terminals 500. The first diode 51 comprises plural second conducting terminals 510. The first electrode 520 is electrically connected with the corresponding first conducting terminal 500 of the first semiconductor switch 50 and the corresponding second conducting terminal 510 of the first diode 51. The second electrode 521 and the third electrode 522 are electrically connected with the corresponding first conducting terminals 500 of the first semiconductor switch 50. The fourth electrode 523 is electrically connected with the corresponding second conducting terminal 510 of the first diode 51. Moreover, the first thermal/electrical conduction structure 55 is arranged between the first electrode 520 and the first lead electrode 524, and electrically connected with the first electrode 520 and the first lead electrode 524.

The third electrode 522 is arranged between the second electrode 521 and the fourth electrode 523. The first lead electrode 524 is arranged beside the second electrode 521 and located at the outermost edge of the second side of the first sub-module 5. In an embodiment, the first semiconductor switch 50 is an insulated-gate bipolar transistor (IGBT). Consequently, the first semiconductor switch 50 comprises three first conducting terminals 500. The three first conducting terminals 500 serve as a gate, an emitter and a collector, respectively. The first electrode 520 is electrically connected with the collector. The second electrode 521 is electrically connected with the gate. The third electrode 522 is electrically connected with the emitter.

The second sub-module 6 comprises a second semiconductor switch 60, a second diode 61, a fifth electrode 620, a sixth electrode 621, a seventh electrode 622, a second thermal/electrical conduction structure 65 and a second lead electrode 624. The fifth electrode 620 and the sixth electrode 621 are located at a first side of the second sub-module 6. The seventh electrode 622 and the second lead electrode 624 are located at a second side of the second sub-module 6. The second semiconductor switch 60 comprises plural third conducting terminals 600. The second diode 61 comprises plural fourth conducting terminals 610. The fifth electrode 620 and the seventh electrode 622 are electrically connected with the corresponding third conducting terminals 600 of the second semiconductor switch 60 and the corresponding fourth conducting terminal 610 of the second diode 61. The sixth electrode 621 is electrically connected with the corresponding third conducting terminal 600 of the second semiconductor switch 60. Moreover, the second thermal/electrical conduction structure 65 is arranged between the sixth electrode 621 and the second lead electrode 624, and electrically connected with the sixth electrode 621 and the second lead electrode 624.

In an embodiment, the second semiconductor switch 60 is an insulated-gate bipolar transistor (IGBT). Consequently, the second semiconductor switch 60 comprises three third conducting terminals 600. The three third conducting terminals 600 serve as a gate, an emitter and a collector, respectively. The fifth electrode 620 is electrically connected with the emitter. The sixth electrode 621 is electrically connected with the gate. The seventh electrode 622 is electrically connected with the collector.

The substrate 7 comprises a first conductive layer 71, a second conductive layer 72 and an insulation layer 73. The first conductive layer 71 is disposed on a first surface 730 of the insulation layer 73. The second conductive layer 72 is disposed on a second surface 731 of the insulation layer 73. The first surface 730 is opposite to the second surface 731. The first conductive layer 71 is electrically connected with the second electrode 521, the third electrode 522, the fourth electrode 523 and the first lead electrode 524 at the second side of the first sub-module 5 and electrically connected with the seventh electrode 622 and the second lead electrode 624 at the second side of the second sub-module 6. Moreover, the first conductive layer 71 is electrically connected with a first end of the conductive pin 3.

Moreover, by an etching process, the first conductive layer 71 is divided into a plurality of conductive blocks including a first conductive block 710, a second conductive block 711, a third conductive block 712 and a fourth conductive block 713. The first conductive block 710 is electrically connected with the first end of the conductive pin 3 and the first lead electrode 524. The second conductive block 711 is electrically connected with the second electrode 521. The third conductive block 712 is electrically connected with the third electrode 522, the fourth electrode 523 and the seventh electrode 622. The fourth conductive block 713 is electrically connected with the second lead electrode 624. The conductive pin 3, the electrodes of the first sub-module 5 and the electrodes of the second sub-module 6 are fixed on the conductive blocks of the first conductive layer 71 through conducting materials 27 (e.g. solder paste, silver paste, silver sintering paste). The insulation layer 73 is made of insulation material with high thermal conductivity (e.g. ceramic material).

In an embodiment, the conductive pin 3, the first sub-module 5 and the second sub-module 6 are separately disposed on the first conductive layer 71 of the substrate 7. Moreover, the spaces between the first conductive layer 71 of the substrate 7, the conductive pin 3, the first sub-module 5 and the second sub-module 6 are filled with isolation structures 80. These isolation structures 80 are made of isolation material (e.g. under-fill epoxy, molding compound).

Moreover, a heat sink 4 is disposed on the second conductive layer 72 of the substrate 7. Consequently, the heat dissipating efficacy of the first sub-module 5 and the second sub-module 6 will be enhanced. In some embodiments, the power module 1 further comprises a thermally-conductive insulation layer 10. The thermally-conductive insulation layer 10 is arranged between the heat sink 4 and the second conductive layer 72. The heat from the second conductive layer 72 is transferred to the heat sink 4 through the thermally-conductive isolation layer 10. Moreover, the second conductive layer 72 and the heat sink 4 are isolated from each other through the thermally-conductive isolation layer 10.

The circuit board 2 is disposed on the conductive pin 3 and electrically connected with the first semiconductor switch 50 and the second semiconductor switch 60 via the conductive pin 3. In this embodiment, the circuit board 2 comprises a first conducting part 20, a second conducting part 21, a third conducting part 22 and a fourth conducting part 24. The first conducting part 20, the second conducting part 21, the third conducting part 22 and the fourth conducting part 24 are disposed on a first surface 23 of the circuit board 2. The first conducting part 20 is electrically connected with a second end of the conductive pin 3. The second conducting part 21 is electrically connected with the first electrode 520 of the first sub-module 5. The third conducting part 22 is electrically connected with the fifth electrode 620 of the second sub-module 6. The fourth conducting part 24 is electrically connected with the sixth electrode 621 of the second sub-module 6. Preferably, the second end of the conductive pin 3, the first electrode 520, the fifth electrode 620 and the sixth electrode 621 are respectively fixed on the first conducting part 20, the second conducting part 21, the third conducting part 22 and the fourth conducting part 24 of the circuit board 2 through the conducting materials 27. The first conducting part 20, the second conducting part 21, the third conducting part 22 and the fourth conducting part 24 are made of electrically-conductive material such as copper. Moreover, the first conducting part 20 is electrically connected with the first electrode 520 through the conductive pin 3, the first conductive block 710 and the first thermal/electrical conduction structure 55.

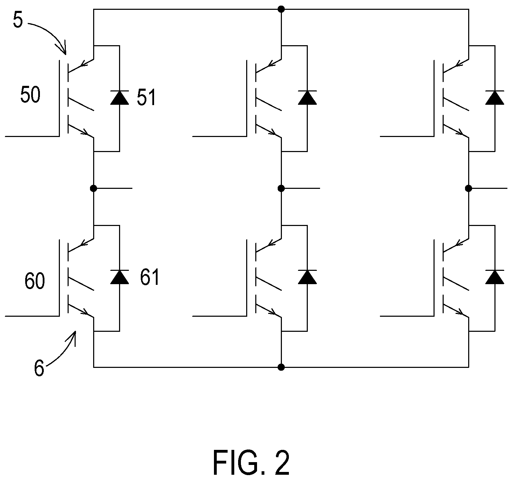

FIG. 2 is a schematic circuit diagram illustrating a three-phase bridge circuit of a three-phase power converter with the power module of FIG. 1. In case that the power module 1 is applied to the three-phase power converter, the power module 1 comprises three first sub-modules 5 and three second sub-modules 6. Each first sub-module 5 and the corresponding second sub-module 6 are collaboratively formed as one leg of the three-phase bridge circuit. Moreover, the first sub-module 5 is formed as a high-voltage-side switching element, and the second sub-module 6 is formed as a low-voltage-side switching element. The first semiconductor switch 50 and the first diode 51 are connected in parallel. The second semiconductor switch 60 and the second diode 61 are connected in parallel, and the second semiconductor switch 60 is electrically connected with the first semiconductor switch 50 via the conductive blocks. In each leg of the bridge circuit, the emitter of the high-voltage-side switching element is electrically connected with the collector of the low-voltage-side switching element. Moreover, as mentioned above, the third electrode 522 of the first sub-module 5 and the seventh electrode 622 of the second sub-module 6 are contacted with the third conductive block 712, the third electrode 522 is electrically connected with the emitter of the first semiconductor switch 50, and the seventh electrode 622 is electrically connected with the collector of the second semiconductor switch 60. In other words, the emitter of the high-voltage-side switching element (i.e. the first sub-module 5) is electrically connected with the collector of the low-voltage-side switching element (i.e. the second sub-module 6).

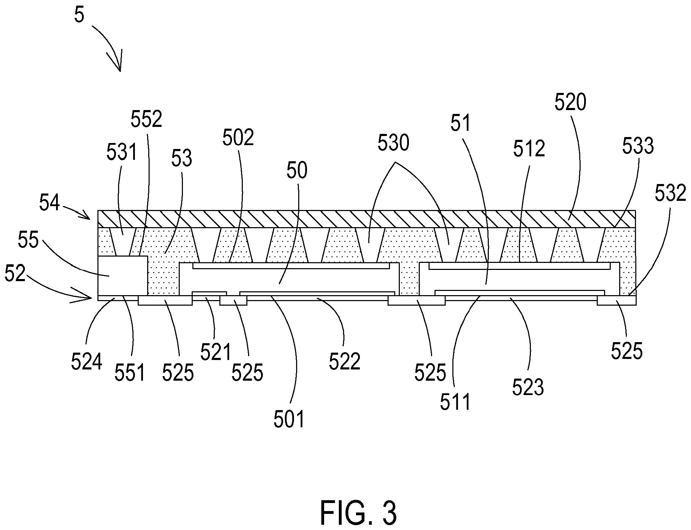

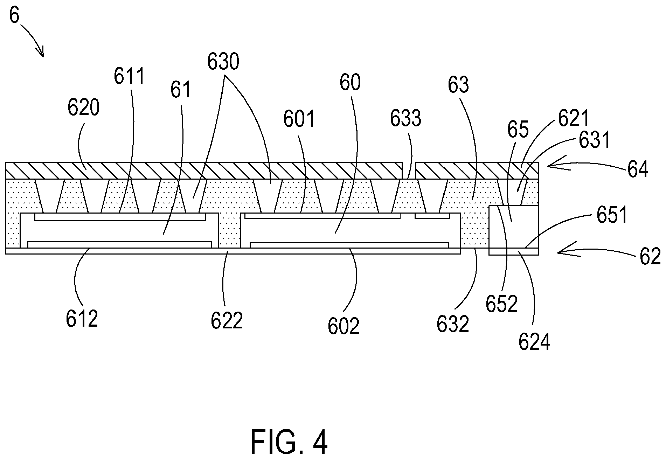

FIG. 3 is a schematic cross-sectional view illustrating an exemplary first sub-module of the power module of FIG. 1. FIG. 4 is a schematic cross-sectional view illustrating an exemplary second sub-module of the power module of FIG. 1. The first sub-module 5 of FIG. 3 and the second sub-module 6 of FIG. 4 are mirror-inverted to the first sub-module 5 and the second sub-module 6 of FIG. 1.

The first sub-module 5 comprises the first semiconductor switch 50, the first diode 51, a first conductive layer 52, a first insulation layer 53, a second conductive layer 54 and the first thermal/electrical conduction structure 55.

Moreover, plural first conductive vias 530 and a second conductive via 531 are formed in the first insulation layer 53. The first conductive layer 52 is disposed on a first surface 532 of the first insulation layer 53, and made of electrically-conductive material such as copper. Moreover, the first conductive layer 52 comprises plural separation structures 525. For example, the separation structures 525 are made of solder mask material or polyimide. The first conductive layer 52 is divided into the second electrode 521, the third electrode 522, the fourth electrode 523 and the first lead electrode 524 through the plural separation structures 525. The second conductive layer 54 is disposed on a second surface 533 of the first insulation layer 53, and made of electrically-conductive material such as copper. The second conductive layer 54 is formed as the first electrode 520. Moreover, the second conductive layer 54 (i.e., the first electrode 520) is contacted with first ends of the plural first conductive vias 530, and contacted with a first end of the second conductive via 531.

The first semiconductor switch 50 is embedded within the first insulation layer 53. The first conducting terminal 500 serving as the gate of the first semiconductor switch 50 and the first conducting terminal 500 serving as the emitter of the first semiconductor switch 50 are disposed on the top surface 501 of the first semiconductor switch 50. The first conducting terminal 500 serving as the collector of the first semiconductor switch 50 is disposed on a second surface 502 of the first semiconductor switch 50. Moreover, the gate of the first semiconductor switch 50 is electrically connected with the second electrode 521. The emitter of the first semiconductor switch 50 is electrically connected with the third electrode 522. The collector of the first semiconductor switch 50 is contacted with second ends of the corresponding first conductive vias 530, and electrically connected with the first electrode 520 through the corresponding first conductive vias 530.

Similarly, the first diode 51 is embedded within the first insulation layer 53. The second conducting terminal 510 on a first surface 511 of the first diode 51 serves as an anode. Moreover, the anode of the first diode 51 is electrically connected with the fourth electrode 523. The second conducting terminal 510 on a second surface 512 of the first diode 51 serves as a cathode. Moreover, the cathode of the first diode 51 is contacted with the second ends of the corresponding first conductive vias 530, and electrically connected with the first electrode 520 through the corresponding first conductive vias 530.

The first thermal/electrical conduction structure 55 is made of metallic material. Moreover, the first thermal/electrical conduction structure 55 may be implemented with the same lead frame or two different lead frames. Consequently, the first thermal/electrical conduction structure 55 has thermally conductive property and electrically conductive property. The first thermal/electrical conduction structure 55 is also embedded within the first insulation layer 53, and partially exposed outside the first insulation layer 53. The first thermal/electrical conduction structure 55 has a first surface 551 and a second surface 552. The first surface 551 of the first thermal/electrical conduction structure 55 is contacted with the first lead electrode 524. The second surface 552 of the first thermal/electrical conduction structure 55 is contacted with a second end of the second conductive via 531, and electrically connected with the first electrode 520.

The second sub-module 6 comprises the second semiconductor switch 60, the second diode 61, a third conductive layer 62, a second insulation layer 63, a fourth conductive layer 64 and the second thermal/electrical conduction structure 65. Moreover, plural third conductive vias 630 and a fourth conductive vias 631 are formed in the second insulation layer 63. The third conductive layer 62 is disposed on a first surface 632 of the second insulation layer 63. The third conductive layer 62 is divided into the seventh electrode 622 and the second lead electrode 624 by an etching process. The fourth conductive layer 64 is disposed on a second surface 633 of the second insulation layer 63. The fourth conductive layer 64 is divided into the fifth electrode 620 and the sixth electrode 621 by an etching process. The fifth electrode 620 and the sixth electrode 621 are contacted with first ends of the third conductive vias 630. Moreover, the sixth electrode 621 is further contacted with a first end of the fourth conductive via 631.

The second semiconductor switch 60 is embedded within the second insulation layer 63. The third conducting terminals 600 serving as the gate and the emitter of the second semiconductor switch 60 are disposed on a first surface 601 of the second semiconductor switch 60. The third conducting terminal 600 serving as the collector is disposed on a second surface 602 of the second semiconductor switch 60. The emitter of the second semiconductor switch 60 is contacted with second ends of the corresponding third conductive vias 630 and electrically connected with the fifth electrode 620. The gate of the second semiconductor switch 60 is contacted with second ends of the corresponding third conductive vias 630, and electrically connected with the sixth electrode 621. The collector of the second semiconductor switch 60 is electrically connected with the seventh electrode 622.

Similarly, the second diode 61 is embedded within the second insulation layer 63. The fourth conducting terminal 610 on a first surface 611 of the second diode 61 serves as anode. Moreover, the anode of the second diode 61 is contacted with the second ends of the corresponding third conductive vias 630, and electrically connected with the fifth electrode 620. The fourth conducting terminal 610 on a second surface 612 of the second diode 61 serves as a cathode. Moreover, the cathode of the second diode 61 is electrically connected with the seventh electrode 622.

The second thermal/electrical conduction structure 65 is also embedded within the second insulation layer 63, and partially exposed outside the second insulation layer 63. The second thermal/electrical conduction structure 65 has a first surface 651 and a second surface 652. The first surface 651 of the second thermal/electrical conduction structure 65 is contacted with the second lead electrode 624. The second surface 652 of the second thermal/electrical conduction structure 65 is contacted with a second end of the fourth conductive via 631, and electrically connected with the sixth electrode 621.

As shown in FIGS. 1, 3 and 4, the configurations of the first semiconductor switch 50 and the second semiconductor switch 60 are similar, and the configurations of the first diode 51 and the second diode 61 are similar. The first semiconductor switch 50 within the first insulation layer 53 and the second semiconductor switch 60 within the second insulation layer 63 are inverted relative to each other. Moreover, the first diode 51 within the first insulation layer 53 and the second diode 61 within the second insulation layer 63 are inverted relative to each other.

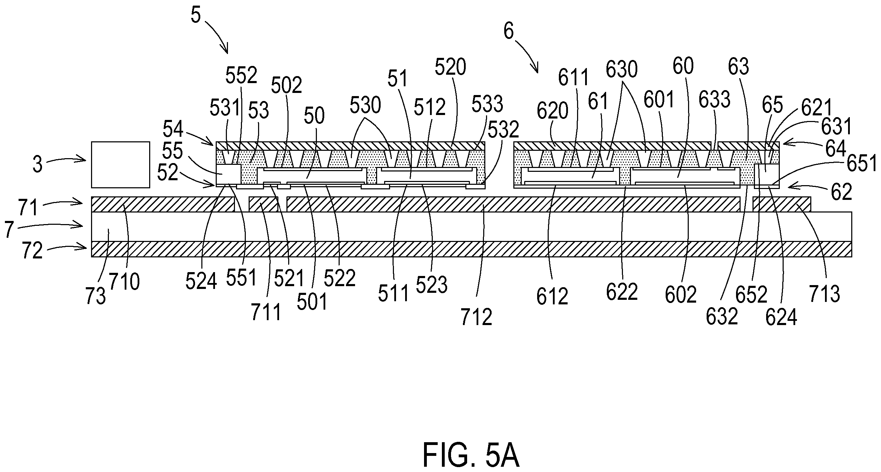

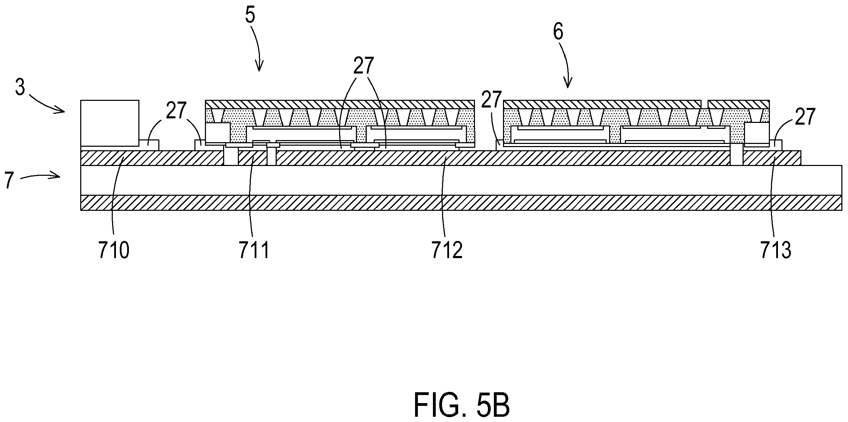

Hereinafter, a process of packaging the power module 1 of FIG. 1 will be illustrated with reference to FIGS. 5A∼5D. FIGS. 5A∼5D are schematic cross-sectional views illustrating the steps of packaging the power module 1 of FIG. 1. Firstly, as shown in FIGS. 5A and 5B, the substrate 7 is provided. Then, through the conducting material 27, the first end of the conductive pin 3 and the first lead electrode 524 are fixed on the first conductive block 710, the second electrode 521 is fixed on the second conductive block 711, the third electrode 522, the fourth electrode 523 and the seventh electrode 622 are fixed on the third conductive block 712, and the second lead electrode 624 is fixed on the fourth conductive block 713.

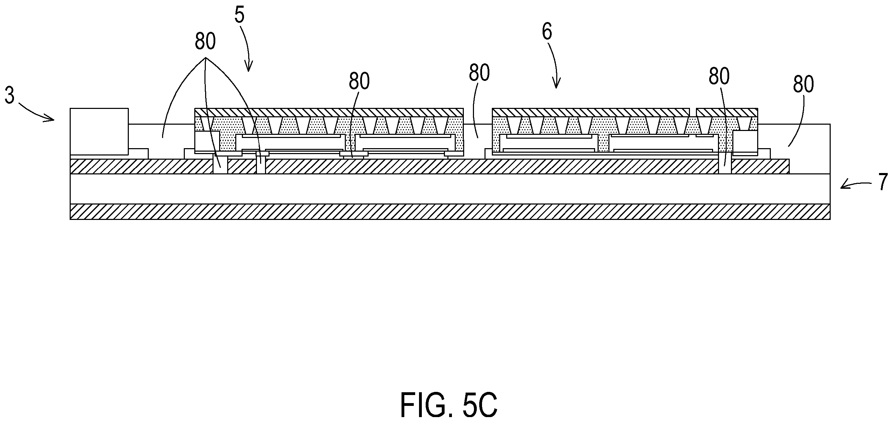

Then, as shown in FIG. 5C, the spaces between the first conductive layer 71 of the substrate 7, the conductive pin 3, the first sub-module 5 and the second sub-module 6 are filled with isolation structures 80.

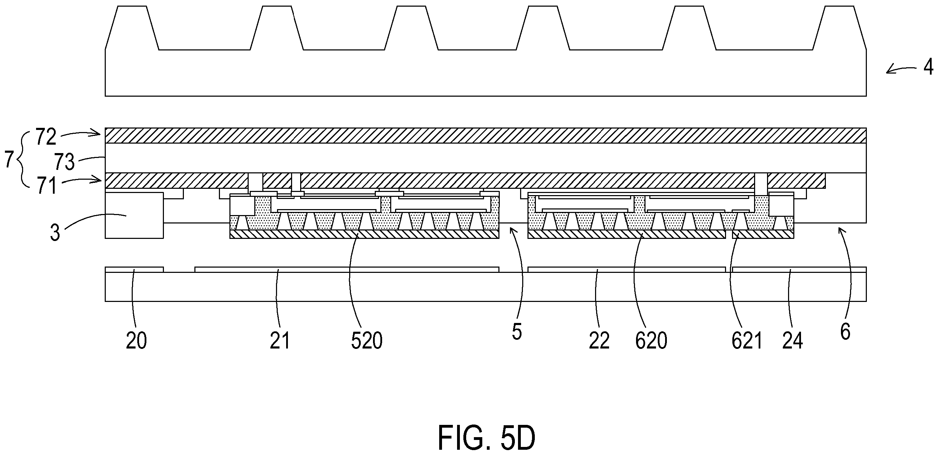

Then, as shown in FIG. 5D, the heat sink 4 is disposed on the second conductive layer 72 of the substrate 7. Optionally, the thermally-conductive insulation layer 10 is arranged between the heat sink 4 and the second conductive layer 72. Moreover, through the conducting material 27, the second end of the conductive pin 3 is fixed on the first conducting part 20, the first electrode 520 of the first sub-module 5 is fixed on the second conducting part 21, the fifth electrode 620 of the second sub-module 6 is fixed on the third conducting part 22, and the sixth electrode 621 of the second sub-module 6 is fixed on the fourth conducting part 24. Meanwhile, the power module 1 of FIG. 1 is fabricated.

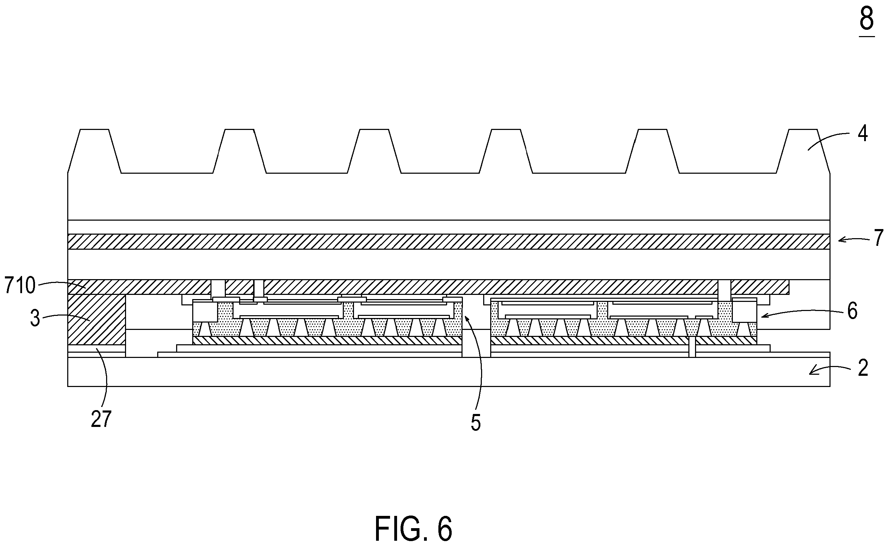

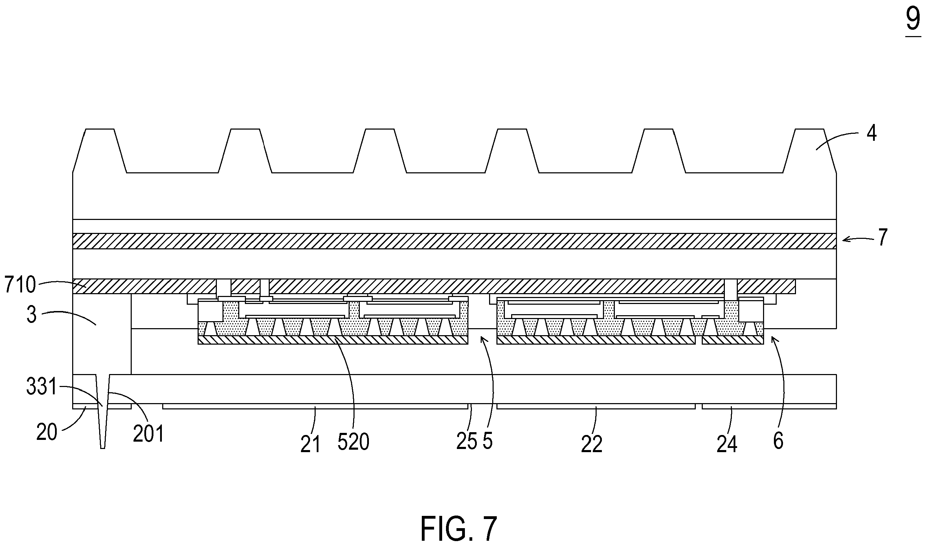

It is noted that numerous modifications and alterations of the power module may be made while retaining the teachings of the invention. Hereinafter, two variant examples of the power module 1 will be illustrated with reference to FIGS. 6 and 7. Component parts and elements corresponding to those of the first embodiment are designated by identical numeral references, and detailed descriptions thereof are omitted.

FIG. 6 is a schematic cross-sectional view illustrating a power module according to a second embodiment of the present invention. In comparison with the power module 1 of FIG. 1, the conductive pin 3 of the power module 8 of this embodiment is not the individual pin. Instead, the conductive pin 3 is extended from the first conductive block 710. Similarly, the conductive pin 3 is fixed on the first conducting part 20 of the circuit board 2 through the conducting material 27.

FIG. 7 is a schematic cross-sectional view illustrating a power module according to a third embodiment of the present invention. In comparison with the power module 1 of FIG. 1, the conductive pin 3 of the power module 9 of this embodiment is not fixed on the first conducting part 20 of the circuit board 2 through the conducting material 27. Instead, a protrusion segment 331 of the conductive pin 3 is inserted into a corresponding insertion slot 201 of the circuit board 2. In the embodiment of FIG. 1, the first conducting part 20, the second conducting part 21, the third conducting part 22 and the fourth conducting part 24 are disposed on the first surface 23 of the circuit board 2. In this embodiment, the first conducting part 20, the second conducting part 21, the third conducting part 22 and the fourth conducting part 24 are disposed on a second surface 25 of the circuit board 2. The first conducting part 20 is aligned with the insertion slot 201. When the protrusion segment 331 of the conductive pin 3 is inserted into the insertion slot 201 of the circuit board 2, the first conducting part 20 is electrically connected with the protrusion segment 331 of the conductive pin 3. Consequently, the first conducting part 20 is electrically connected with the first electrode 520 through the conductive pin 3, the first conductive block 710 and the first thermal/electrical conduction structure 55. Moreover, when the protrusion segment 331 of the conductive pin 3 is inserted into the insertion slot 201 of the circuit board 2, the first sub-module 5 and the second sub-module 6 are separated from the circuit board 2 by a gap. Consequently, it is not necessary to solder the first sub-module 5 and the second sub-module 6 on the circuit board 2. It is noted that numerous modifications and alterations may be made while retaining the teachings of the invention. In another embodiment, when the protrusion segment 331 of the conductive pin 3 is inserted into the insertion slot 201 of the circuit board 2, the first sub-module 5 and the second sub-module 6 are attached on the circuit board 2.

From the above descriptions, the present invention provides the power module. The semiconductor switches and the diodes are embedded within insulation layers. Consequently, a first sub-module and a second sub-module are formed as a high-voltage-side switching element and a low-voltage-side switching element of a bridge circuit. The first sub-module and the second sub-module are disposed on a first surface of a substrate. An electrode of the first sub-module and some electrodes of the second sub-module are electrically connected with corresponding conducting parts of a circuit board. A heat sink is disposed on a second surface of the substrate. The heat of the power module can be dissipated away through the circuit board and the heat sink. Since the heat can be dissipated away in two directions, the heat dissipating efficiency is enhanced. Moreover, it is not necessary to embed substrates within the first sub-module and the second sub-module. That is, the first sub-module and the second sub-module are disposed on the substrate. Consequently, the process of packaging the power module of the present invention is simplified. Moreover, the first sub-module (i.e., the high-voltage-side switching element) and the second sub-module (i.e., the low-voltage-side switching element) are not connected with each other by the wire-bonded technology. Consequently the power module of the present invention has reduced parasitic inductance, increased switching efficiency, reduced impedance and increased power conversion efficiency.

In summary,
A power module 1, 8, 9 is disclosed including a substrate 7, a first sub-module 5, a second sub-module 6 and a circuit board 2. The semiconductor switches 50, 60 and the diodes 51, 61 of the first sub-module 5 and the second sub-module 6 are embedded within insulation layers 80. Consequently, the first sub-module 5 and the second sub-module 6 are formed as a high-voltage-side switching element and a low-voltage-side switching element of a bridge circuit. The first sub-module 5 and the second sub-module 6 are disposed on a first surface 730 of the substrate 7. An electrode 520 of the first sub-module 5 and some electrodes 620, 621 of the second sub-module 6 are electrically connected with corresponding conducting parts 21, 22, 24 of a circuit board 2. A heat sink 4 is disposed on a second surface 731 of the substrate 7.

## Claims

1. A power module (1, 8, 9), comprising:
a substrate (7) comprising a first conductive layer (71) disposed on a first surface (730) and a second conductive layer (72) disposed on a second surface (731) opposite to the first surface (730), the first conductive layer (71) comprising a plurality of conductive blocks (710, 711, 712, 713) including a first conductive block (710), a second conductive block (711), a third conductive block (712) and a fourth conductive block (713);
a first sub-module (5) disposed on the first conductive layer (71), the first sub-module (5) comprising a first semiconductor switch (50) and a first diode (51) which is connected in parallel with the first semiconductor switch (50), wherein the first sub-module (5) further comprises a first electrode (520), a second electrode (521), a third electrode (522) and a fourth electrode (523) and the third electrode (522) is electrically connected with the third conductive block (712);
a second sub-module (6) disposed on the first conductive layer (71), the second sub-module (6) comprising a second semiconductor switch (60) and a second diode (61) which is connected in parallel with the second semiconductor switch (60), the second semiconductor switch (60) being electrically connected with the first semiconductor switch (50) through the plurality of conductive blocks (710, 711, 712, 713), wherein the second sub-module (6) further comprises a fifth electrode (620), a sixth electrode (621) and a seventh electrode (622), and the seventh electrode (622) is electrically connected with the third conductive block (712);
a conductive pin (3) disposed on the first conductive layer (71) and electrically connected with at least one of the conductive blocks (710) wherein a first end of the conductive pin (3) is electrically connected with the first conductive block (710);
a circuit board (2) disposed on the conductive pin (3) and electrically connected with the first semiconductor switch (50) and the second semiconductor switch (60) through the conductive pin (3); and
a heat sink (4) disposed on the second conductive layer (72), wherein the first sub-module (5) further comprises a first thermal/electrical conduction structure (55) and a first lead electrode (524), and the second sub-module (6) further comprises a second thermal/electrical conduction structure (65) and a second lead electrode (624), wherein the first thermal/electrical conduction structure (55) is arranged between the first electrode (520) and the first lead electrode (524) and electrically connected with the first electrode (520) and the first lead electrode (524), wherein the second thermal/electrical conduction structure (65) is arranged between the sixth electrode (621) and the second lead electrode (624), and electrically connected with the sixth electrode (621) and the second lead electrode (624), wherein the first lead electrode (524) is electrically connected with the first conductive block (710).

2. The power module according to claim 1, wherein the first semiconductor switch (50) comprises plural first conducting terminals (500), and the first diode (51) comprises plural second conducting terminals (510), wherein the first electrode (520) is electrically connected with the corresponding first conducting terminal (500) of the first semiconductor switch (50) and the corresponding second conducting terminal (510) of the first diode (51), the second electrode (521) and the third electrode (522) are electrically connected with the corresponding first conducting terminals (500) of the first semiconductor switch (50), and the fourth electrode (523) is electrically connected with the corresponding second conducting terminal (510) of the first diode (51), wherein the second electrode (521) is electrically connected with the second conductive block (711), and the fourth electrode (523) is electrically connected with the third conductive block (712).

3. The power module according to claim 2, wherein the second semiconductor switch (60) comprises plural third conducting terminals (600), and the second diode (61) comprises plural fourth conducting terminals (610), wherein the fifth electrode (620) and the seventh electrode (622) are electrically connected with the corresponding third conducting terminals (600) of the second semiconductor switch (60) and the corresponding fourth conducting terminal (610) of the second diode (61), the sixth electrode (621) is electrically connected with the corresponding third conducting terminal (600) of the second semiconductor switch (60).

4. The power module according to claim 1, wherein the circuit board (2) further comprises a first conducting part (20), a second conducting part (21), a third conducting part (22) and a fourth conducting part (24), wherein the first conducting part (20), the second conducting part (21), the third conducting part (22) and the fourth conducting part (24) are disposed on a first surface (23) of the circuit board (2), wherein the second conducting part (21) is electrically connected with the first electrode (520), the third conducting part (22) is electrically connected with the fifth electrode (620), and the fourth conducting part (24) is electrically connected with the sixth electrode (621).

5. The power module according to claim 1 or 4, wherein the first semiconductor switch (50) is an insulated-gate bipolar transistor, and the first semiconductor switch (50) comprises three first conducting terminals (500), wherein the three first conducting terminals (500) serve as a gate, an emitter and a collector, respectively, wherein the first electrode (520) is electrically connected with the collector of the first semiconductor switch (50), the second electrode (521) is electrically connected with the gate of the first semiconductor switch (50), and the third electrode (522) is electrically connected with the emitter of the first semiconductor switch (50).

6. The power module according to claim 5, wherein the first sub-module (5) further comprises:
a first insulation layer (53), wherein plural first conductive vias (530) and a second conductive via (531) are formed in the first insulation layer (53);
a first conductive layer (52) disposed on a first surface (532) of the first insulation layer (53), and comprising plural separation structures (525), wherein the first conductive layer (52) is divided into the second electrode (521), the third electrode (522), the fourth electrode (523) and the first lead electrode (524) through the plural separation structures (525); and
a second conductive layer (54) disposed on a second surface (533) of the first insulation layer (53), wherein the second conductive layer (54) is contacted with first ends of the plural first conductive vias (530) and contacted with a first end of the second conductive via (531).

7. The power module according to claim 6, wherein the first semiconductor switch (50), the first diode (51) and the first thermal/electrical conduction structure (55) are embedded within the first insulation layer (53), and the first thermal/electrical conduction structure (55) has a first surface (551) and a second surface (552), wherein the first conducting terminal (500) serving as the gate of the first semiconductor switch (50) is electrically connected with the second electrode (521), the first conducting terminal (500) serving as the emitter of the first semiconductor switch (50) is electrically connected with the third electrode (522), and the first conducting terminal (500) serving as the collector of the first semiconductor switch (50) is contacted with the second ends of the corresponding first conductive vias (530) so as to be electrically connected with the first electrode (520), wherein the second conducting terminal (510) serving as an anode of the first diode (51) is electrically connected with the fourth electrode (523), and the second conducting terminal (510) serving as a cathode of the first diode (51) is contacted with the second ends of the corresponding first conductive vias (530) so as to be electrically connected with the first electrode (520), wherein the first surface (551) of the first thermal/electrical conduction structure (55) is contacted with the first lead electrode (524), and the second surface (552) of the first thermal/electrical conduction structure (55) is contacted with a second end of the second conductive via (531) so as to be electrically connected with the first electrode (520).

8. The power module according to one of claims 1 or 5-7, wherein the second semiconductor switch (60) is an insulated-gate bipolar transistor, and the second semiconductor switch (60) comprises three third conducting terminals (600), wherein the three third conducting terminals (600) serve as a gate, an emitter and a collector, respectively, wherein the fifth electrode (620) is electrically connected with the emitter of the second semiconductor switch (60), the sixth electrode (621) is electrically connected with the gate of the second semiconductor switch (60), and the seventh electrode (622) is electrically connected with the collector of the second semiconductor switch (60).

9. The power module according to claim 8, wherein the second sub-module (6) further comprises:
a second insulation layer (63), wherein plural third conductive vias (630) and a fourth conductive via (631) are formed in the second insulation layer (63);
a third conductive layer (62) disposed on a first surface (632) of the second insulation layer (63), and divided into the seventh electrode (622) and the second lead electrode (624); and
a fourth conductive layer (64) disposed on a second surface (633) of the second insulation layer (63), wherein the fourth conductive layer (64) is divided into the fifth electrode (620) and the sixth electrode (621), wherein the fifth electrode (620) and the sixth electrode (621) are contacted with first ends of the plural third conductive vias (630), and the sixth electrode (621) is further contacted with a first end of the fourth conductive via (631).

10. The power module according to claim 9, wherein the second semiconductor switch (60), the second diode (61) and the second thermal/electrical conduction structure (65) are embedded within the second insulation layer (63), and the second thermal/electrical conduction structure (65) has a first surface (651) and a second surface (652), wherein the third conducting terminal (600) serving as the emitter of the second semiconductor switch (60) is contacted with second ends of the corresponding third conductive vias (630) so as to be electrically connected with the fifth electrode (620), the third conducting terminal (600) serving as the gate of the second semiconductor switch (60) is contacted with the second end of the corresponding third conductive via (630) so as to be electrically connected with the sixth electrode (621), and the third conducting terminal (600) serving as the collector of the second semiconductor switch (60) is electrically connected with the seventh electrode (622), wherein the fourth conducting terminal (610) serving as an anode of the second diode (61) is contacted with the second ends of the corresponding third conductive vias (630) so as to be electrically connected with the fifth electrode (620), and the fourth conducting terminal (610) serving as a cathode of the second diode (61) is electrically connected with the seventh electrode (622), wherein the first surface (651) of the second thermal/electrical conduction structure (65) is contacted with the second lead electrode (624), and the second surface (652) of the second thermal/electrical conduction structure (65) is contacted with a second end of the fourth conductive via (631) so as to be electrically connected with the sixth electrode (621).

11. The power module according to one of claims 1 or 5-10, wherein the fourth conductive block (713) of the substrate (7) is electrically connected with the second lead electrode (624).

12. The power module according to one of claims 1 or 5-11, wherein the conductive pin (3) is a pin or the conductive pin (3) is extended from the first conductive block (710).

13. The power module according to one of claims 1 or 5-12, wherein the conductive pin (3) has a protrusion segment (331), and the circuit board (2) has an insertion slot (201) corresponding to the protrusion segment (331), wherein the protrusion segment (331) of the conductive pin (3) is inserted into the insertion slot (201) of the circuit board (2), wherein a first conducting part (20) is disposed on a second surface (25) of the circuit board (2) and aligned with the insertion slot (201), wherein when the protrusion segment (331) of the conductive pin (3) is inserted into the insertion slot (201), the first conducting part (20) is electrically connected with the insertion slot (201), and the first sub-module (5) and the second sub-module (6) are separated from the circuit board (2) by a gap.

## Patentansprüche

1. Leistungsmodul (1, 8, 9), umfassend:
ein Substrat (7) umfassend eine erste leitende Schicht (71), die auf einer ersten Fläche (730) angeordnet ist, und eine zweite leitende Schicht (72), die auf einer zweiten Fläche (731) gegenüber der ersten Fläche (730) angeordnet ist, wobei die erste leitende Schicht (71) eine Vielzahl von leitenden Blöcken (710, 711, 712, 713) umfasst, einschließlich eines ersten leitenden Blocks (710), eines zweiten leitenden Blocks (711), eines dritten leitenden Blocks (712) und eines vierten leitenden Blocks (713);
ein erstes Untermodul (5), das auf der ersten leitenden Schicht (71) angeordnet ist, wobei das erste Untermodul (5) einen ersten Halbleiterschalter (50) und eine erste Diode (51) umfasst, die parallel zu dem ersten Halbleiterschalter (50) geschaltet ist, wobei das erste Untermodul (5) ferner eine erste Elektrode (520), eine zweite Elektrode (521), eine dritte Elektrode (522) und eine vierte Elektrode (523) umfasst und die dritte Elektrode (522) elektrisch mit dem dritten leitenden Block (712) verbunden ist;
ein zweites Untermodul (6), das auf der ersten leitenden Schicht (71) angeordnet ist, wobei das zweite Untermodul (6) einen zweiten Halbleiterschalter (60) und eine zweite Diode (61) aufweist, die parallel zu dem zweiten Halbleiterschalter (60) geschaltet ist, wobei der zweite Halbleiterschalter (60) elektrisch mit dem ersten Halbleiterschalter (50) über die Vielzahl von leitenden Blöcken (710, 711, 712, 713) verbunden ist, wobei das zweite Untermodul (6) ferner eine fünfte Elektrode (620), eine sechste Elektrode (621) und eine siebte Elektrode (622) umfasst, und die siebte Elektrode (622) elektrisch mit dem dritten leitenden Block (712) verbunden ist;
einen leitfähigen Stift (3), der auf der ersten leitfähigen Schicht (71) angeordnet und elektrisch mit mindestens einem der leitfähigen Blöcke (710) verbunden ist, wobei ein erstes Ende des leitfähigen Stifts (3) elektrisch mit dem ersten leitfähigen Block (710) verbunden ist;
eine Leiterplatte (2), die auf dem leitenden Stift (3) angeordnet und elektrisch mit dem ersten Halbleiterschalter (50) und dem zweiten Halbleiterschalter (60) über den leitenden Stift (3) verbunden ist; und
eine Wärmesenke (4), die auf der zweiten leitenden Schicht (72) angeordnet ist, wobei das erste Untermodul (5) ferner eine erste thermisch/elektrisch leitende Struktur (55) und eine erste Zuleitungselektrode (524) umfasst, und das zweite Untermodul (6) ferner eine zweite thermisch/elektrisch leitende Struktur (65) und eine zweite Zuleitungselektrode (624) umfasst, wobei die erste thermisch/elektrisch leitende Struktur (55) zwischen der ersten Elektrode (520) und der ersten Zuleitungselektrode (524) angeordnet und elektrisch mit der ersten Elektrode (520) und der ersten Zuleitungselektrode (524) verbunden ist, wobei die zweite thermisch/elektrisch leitende Struktur (65) zwischen der sechsten Elektrode (621) und der zweiten Zuleitungselektrode (624) angeordnet und elektrisch mit der sechsten Elektrode (621) und der zweiten Zuleitungselektrode (624) verbunden ist, wobei die erste Zuleitungselektrode (524) elektrisch mit dem ersten leitenden Block (710) verbunden ist.

2. Leistungsmodul nach Anspruch 1, wobei der erste Halbleiterschalter (50) mehrere erste leitende Anschlüsse (500) aufweist und die erste Diode (51) mehrere zweite leitende Anschlüsse (510) aufweist, wobei die erste Elektrode (520) elektrisch mit dem entsprechenden ersten leitenden Anschluss (500) des ersten Halbleiterschalters (50) und dem entsprechenden zweiten leitenden Anschluss (510) der ersten Diode (51) verbunden ist, wobei die zweite Elektrode (521) und die dritte Elektrode (522) elektrisch mit den entsprechenden ersten leitenden Anschlüssen (500) des ersten Halbleiterschalters (50) verbunden sind, und wobei die vierte Elektrode (523) elektrisch mit dem entsprechenden zweiten leitenden Anschluss (510) der ersten Diode (51) verbunden ist, wobei die zweite Elektrode (521) elektrisch mit dem zweiten leitenden Block (711) verbunden ist, und wobei die vierte Elektrode (523) elektrisch mit dem dritten leitenden Block (712) verbunden ist.

3. Leistungsmodul nach Anspruch 2, wobei der zweite Halbleiterschalter (60) mehrere dritte leitende Anschlüsse (600) aufweist und die zweite Diode (61) mehrere vierte leitende Anschlüsse (610) aufweist, wobei die fünfte Elektrode (620) und die siebte Elektrode (622) elektrisch mit den entsprechenden dritten leitenden Anschlüssen (600) des zweiten Halbleiterschalters (60) und dem entsprechenden vierten leitenden Anschluss (610) der zweiten Diode (61) verbunden sind, wobei die sechste Elektrode (621) elektrisch mit dem entsprechenden dritten leitenden Anschluss (600) des zweiten Halbleiterschalters (60) verbunden ist.

4. Leistungsmodul nach Anspruch 1, wobei die Leiterplatte (2) ferner einen ersten leitenden Teil (20), einen zweiten leitenden Teil (21), einen dritten leitenden Teil (22) und einen vierten leitenden Teil (24) umfasst, wobei der erste leitende Teil (20), der zweite leitende Teil (21), der dritte leitende Teil (22) und der vierte leitende Teil (24) auf einer ersten Fläche (23) der Leiterplatte (2) angeordnet sind, wobei der zweite leitende Teil (21) elektrisch mit der ersten Elektrode (520) verbunden ist, der dritte leitende Teil (22) elektrisch mit der fünften Elektrode (620) verbunden ist und der vierte leitende Teil (24) elektrisch mit der sechsten Elektrode (621) verbunden ist.

5. Leistungsmodul nach Anspruch 1 oder 4, wobei der erste Halbleiterschalter (50) ein Bipolartransistor mit isoliertem Gate ist und der erste Halbleiterschalter (50) drei erste leitende Anschlüsse (500) aufweist, wobei die drei ersten leitenden Anschlüsse (500) jeweils als Gate, Emitter und Kollektor dienen, wobei die erste Elektrode (520) elektrisch mit dem Kollektor des ersten Halbleiterschalters (50) verbunden ist, die zweite Elektrode (521) elektrisch mit dem Gate des ersten Halbleiterschalters (50) verbunden ist, und die dritte Elektrode (522) elektrisch mit dem Emitter des ersten Halbleiterschalters (50) verbunden ist.

6. Leistungsmodul nach Anspruch 5, wobei das erste Untermodul (5) ferner umfasst:
eine erste Isolationsschicht (53), wobei mehrere erste leitende Durchkontaktierungen (530) und eine zweite leitende Durchkontaktierung (531) in der ersten Isolationsschicht (53) ausgebildet sind;
eine erste leitende Schicht (52), die auf einer ersten Fläche (532) der ersten Isolierschicht (53) angeordnet ist und mehrere Trennstrukturen (525) aufweist, wobei die erste leitende Schicht (52) durch die mehreren Trennstrukturen (525) in die zweite Elektrode (521), die dritte Elektrode (522), die vierte Elektrode (523) und die erste Leitungselektrode (524) unterteilt ist; und
eine zweite leitende Schicht (54), die auf einer zweiten Fläche (533) der ersten Isolierschicht (53) angeordnet ist, wobei die zweite leitende Schicht (54) mit ersten Enden der mehreren ersten leitenden Durchkontaktierungen (530) und mit einem ersten Ende der zweiten leitenden Durchkontaktierung (531) kontaktiert ist.

7. Leistungsmodul nach Anspruch 6, wobei der erste Halbleiterschalter (50), die erste Diode (51) und die erste thermisch/elektrisch leitende Struktur (55) in die erste Isolierschicht (53) eingebettet sind, und die erste thermisch/elektrisch leitende Struktur (55) eine erste Fläche (551) und eine zweite Fläche (552) aufweist, wobei der erste leitende Anschluss (500), der als das Gate des ersten Halbleiterschalters (50) dient, elektrisch mit der zweiten Elektrode (521) verbunden ist, der erste leitende Anschluss (500), der als Emitter des ersten Halbleiterschalters (50) dient, elektrisch mit der dritten Elektrode (522) verbunden ist, und der erste leitende Anschluss (500), der als Kollektor des ersten Halbleiterschalters (50) dient, mit den zweiten Enden der entsprechenden ersten leitenden Durchkontaktierungen (530) kontaktiert ist, so dass er elektrisch mit der ersten Elektrode (520) verbunden ist, wobei der zweite leitende Anschluss (510), der als eine Anode der ersten Diode (51) dient, elektrisch mit der vierten Elektrode (523) verbunden ist, und der zweite leitende Anschluss (510), der als eine Kathode der ersten Diode (51) dient, mit den zweiten Enden der entsprechenden ersten leitenden Durchkontaktierungen (530) kontaktiert ist, so dass er elektrisch mit der ersten Elektrode (520) verbunden ist, wobei die erste Fläche (551) der ersten thermisch/elektrisch leitenden Struktur (55) mit der ersten Leitungselektrode (524) kontaktiert ist und die zweite Fläche (552) der ersten thermisch/elektrisch leitenden Struktur (55) mit einem zweiten Ende der zweiten leitenden Durchkontaktierung (531) kontaktiert ist, so dass sie elektrisch mit der ersten Elektrode (520) verbunden ist.

8. Leistungsmodul nach einem der Ansprüche 1 oder 5-7, wobei der zweite Halbleiterschalter (60) ein Bipolartransistor mit isoliertem Gate ist und der zweite Halbleiterschalter (60) drei dritte leitende Anschlüsse (600) aufweist, wobei die drei dritten leitenden Anschlüsse (600) als Gate, Emitter bzw. Kollektor dienen, wobei die fünfte Elektrode (620) elektrisch mit dem Emitter des zweiten Halbleiterschalters (60) verbunden ist, die sechste Elektrode (621) elektrisch mit dem Gate des zweiten Halbleiterschalters (60) verbunden ist, und die siebte Elektrode (622) elektrisch mit dem Kollektor des zweiten Halbleiterschalters (60) verbunden ist.

9. Leistungsmodul nach Anspruch 8, wobei das zweite Untermodul (6) ferner umfasst:
eine zweite Isolationsschicht (63), wobei mehrere dritte leitende Durchkontaktierungen (630) und eine vierte leitende Durchkontaktierung (631) in der zweiten Isolationsschicht (63) ausgebildet sind;
eine dritte leitende Schicht (62), die auf einer ersten Fläche (632) der zweiten Isolierschicht (63) angeordnet und in die siebte Elektrode (622) und die zweite Zuleitungselektrode (624) unterteilt ist; und
eine vierte leitende Schicht (64), die auf einer zweiten Fläche (633) der zweiten Isolierschicht (63) angeordnet ist, wobei die vierte leitende Schicht (64) in die fünfte Elektrode (620) und die sechste Elektrode (621) unterteilt ist, wobei die fünfte Elektrode (620) und die sechste Elektrode (621) mit ersten Enden der mehreren dritten leitenden Durchkontaktierungen (630) kontaktiert sind und die sechste Elektrode (621) ferner mit einem ersten Ende der vierten leitenden Durchkontaktierung (631) kontaktiert ist.

10. Leistungsmodul nach Anspruch 9, wobei der zweite Halbleiterschalter (60), die zweite Diode (61) und die zweite thermisch/elektrisch leitende Struktur (65) in die zweite Isolationsschicht (63) eingebettet sind und die zweite thermisch/elektrisch leitende Struktur (65) eine erste Fläche (651) und eine zweite Fläche (652) aufweist, wobei der dritte leitende Anschluss (600), der als der Emitter des zweiten Halbleiterschalters (60) dient, mit zweiten Enden der entsprechenden dritten leitenden Durchkontaktierungen (630) kontaktiert ist, so dass er elektrisch mit der fünften Elektrode (620) verbunden ist, wobei der dritte leitende Anschluss (600), der als das Gate des zweiten Halbleiterschalters (60) dient, mit dem zweiten Ende der entsprechenden dritten leitenden Durchkontaktierung (630) kontaktiert ist, so dass er elektrisch mit der sechsten Elektrode (621) verbunden ist, und der dritte leitende Anschluss (600), der als Kollektor des zweiten Halbleiterschalters (60) dient, elektrisch mit der siebten Elektrode (622) verbunden ist, wobei der vierte leitende Anschluss (610), der als Anode der zweiten Diode (61) dient, mit den zweiten Enden der entsprechenden dritten leitenden Durchkontaktierungen (630) kontaktiert ist, so dass er elektrisch mit der fünften Elektrode (620) verbunden ist, und der vierte leitende Anschluss (610), der als Kathode der zweiten Diode (61) dient, elektrisch mit der siebten Elektrode (622) verbunden ist, wobei die erste Fläche (651) der zweiten thermisch/elektrisch leitenden Struktur (65) mit der zweiten Zuleitungselektrode (624) kontaktiert ist, und die zweite Fläche (652) der zweiten thermisch/elektrisch leitenden Struktur (65) mit einem zweiten Ende des vierten leitenden Durchgangs (631) kontaktiert ist, so dass sie elektrisch mit der sechsten Elektrode (621) verbunden ist.

11. Leistungsmodul nach einem der Ansprüche 1 oder 5-10, wobei der vierte leitende Block (713) des Substrats (7) elektrisch mit der zweiten Zuleitungselektrode (624) verbunden ist.

12. Leistungsmodul nach einem der Ansprüche 1 oder 5-11, wobei der leitende Stift (3) ein Stift ist oder der leitende Stift (3) aus dem ersten leitenden Block (710) herausgeführt ist.

13. Leistungsmodul nach einem der Ansprüche 1 oder 5-12, wobei der leitende Stift (3) ein vorstehendes Segment (331) aufweist und die Leiterplatte (2) einen Einführungsschlitz (201) aufweist, der dem vorstehenden Segment (331) entspricht, wobei das vorstehende Segment (331) des leitenden Stifts (3) in den Einführungsschlitz (201) der Leiterplatte (2) eingeführt wird, wobei ein erstes leitendes Teil (20) auf einer zweiten Fläche (25) der Leiterplatte (2) angeordnet und mit dem Einführungsschlitz (201) ausgerichtet ist, wobei, wenn das Vorsprungsegment (331) des leitenden Stifts (3) in den Einführungsschlitz (201) eingeführt wird, das erste leitende Teil (20) elektrisch mit dem Einführungsschlitz (201) verbunden ist, und das erste Untermodul (5) und das zweite Untermodul (6) von der Leiterplatte (2) durch einen Spalt getrennt sind.

## Revendications

1. Un module d'alimentation (1, 8, 9) comprenant :
un substrat (7) comprenant une première couche conductrice (71) disposée sur une première surface (730) et une deuxième couche conductrice (72) disposée sur une deuxième surface (731) opposée à la première surface (730), dans lequel la première couche conductrice (71) comprend une pluralité de blocs conducteurs (710, 711, 712, 713) comprenant un premier bloc conducteur (710), un deuxième bloc conducteur (711), un troisième bloc conducteur (712) et un quatrième bloc conducteur (713) ;
un premier sous-module (5) disposé sur la première couche conductrice (71), le premier sous-module (5) comprenant un premier commutateur à semi-conducteur (50) et une première diode (51) connectée en parallèle avec le premier commutateur à semi-conducteur (50), le premier sous-module (5) comprenant en outre une première électrode (520), une deuxième électrode (521), une troisième électrode (522) et une quatrième électrode (523), la troisième électrode (522) étant connectée électriquement au troisième bloc conducteur (712) ;
un deuxième sous-module (6) disposé sur la première couche conductrice (71), le deuxième sous-module (6) ayant un deuxième commutateur à semi-conducteur (60) et une deuxième diode (61) connectée en parallèle avec le deuxième commutateur à semi-conducteur (60), le deuxième commutateur à semi-conducteur (60) étant connecté électriquement au premier commutateur à semi-conducteur (50) via la pluralité de blocs conducteurs (710), 711, 712, 713), le deuxième sous-module (6) comprenant en outre une cinquième électrode (620), une sixième électrode (621) et une septième électrode (622), la septième électrode (622) étant connectée électriquement au troisième bloc conducteur (712) ;
une broche conductrice (3) disposée sur la première couche conductrice (71) et connectée électriquement à au moins un des blocs conducteurs (710), dans lequel une première extrémité de la broche conductrice (3) est connectée électriquement au premier bloc conducteur (710) ;
une carte de circuit imprimé (2) disposée sur ladite broche conductrice (3) et connectée électriquement audit premier commutateur à semi-conducteur (50) et audit second commutateur à semi-conducteur (60) par l'intermédiaire de ladite broche conductrice (3) ; et
un dissipateur thermique (4) disposé sur la deuxième couche conductrice (72), le premier sous-module (5) comprenant en outre une première structure thermiquement/électriquement conductrice (55) et une première électrode de plomb (524), et le deuxième sous-module (6) comprenant en outre une deuxième structure thermiquement/électriquement conductrice (65) et une deuxième électrode de plomb (624), dans lequel la première structure conductrice thermique/électrique (55) est disposée entre la première électrode (520) et la première électrode de plomb (524) et est électriquement connectée à la première électrode (520) et à la première électrode de plomb (524), dans lequel la deuxième structure conductrice thermique/électrique (65) est disposée entre la sixième électrode (621) et la deuxième électrode de plomb (624) et est connectée électriquement à la sixième électrode (621) et à la deuxième électrode de plomb (624), la première électrode de plomb (524) étant connectée électriquement au premier bloc conducteur (710).

2. Le module d'alimentation selon la revendication 1, dans lequel le premier commutateur à semi-conducteur (50) comporte une pluralité de premières bornes conductrices (500) et la première diode (51) comporte une pluralité de secondes bornes conductrices (510), la première électrode (520) étant connectée électriquement à la première borne conductrice correspondante (500) du premier commutateur à semi-conducteur (50) et à la seconde borne conductrice correspondante (510) de la première diode (51), dans lequel la deuxième électrode (521) et la troisième électrode (522) sont électriquement connectées aux premières bornes conductrices correspondantes (500) du premier commutateur à semi-conducteur (50), et dans lequel la quatrième électrode (523) est électriquement connectée à la deuxième borne conductrice correspondante (510) de la première diode (51), dans lequel la deuxième électrode (521) est électriquement connectée au deuxième bloc conducteur (711), et dans lequel la quatrième électrode (523) est électriquement connectée au troisième bloc conducteur (712).

3. Le module d'alimentation selon la revendication 2, dans lequel le deuxième commutateur à semi-conducteur (60) possède une pluralité de troisièmes bornes conductrices (600) et la deuxième diode (61) possède une pluralité de quatrièmes bornes conductrices (610), dans laquelle la cinquième électrode (620) et la septième électrode (622) sont électriquement connectées à la troisième borne conductrice correspondante (600) du deuxième commutateur à semi-conducteur (60) et à la quatrième borne conductrice correspondante (610) de la deuxième diode (61), la sixième électrode (621) étant électriquement connectée à la troisième borne conductrice correspondante (600) du deuxième commutateur à semi-conducteur (60).

4. Le module d'alimentation selon la revendication 1, dans lequel la carte de circuit imprimé (2) comprend en outre une première partie conductrice (20), une deuxième partie conductrice (21), une troisième partie conductrice (22) et une quatrième partie conductrice (24), dans lequel la première partie conductrice (20), la deuxième partie conductrice (21), ladite troisième partie conductrice (22) et ladite quatrième partie conductrice (24) sont disposées sur une première surface (23) de ladite carte de circuit imprimé (2), ladite deuxième partie conductrice (21) étant connectée électriquement à ladite première électrode (520), ladite troisième partie conductrice (22) étant connectée électriquement à ladite cinquième électrode (620), et ladite quatrième partie conductrice (24) étant connectée électriquement à ladite sixième électrode (621).

5. Le module d'alimentation selon la revendication 1 ou 4, dans lequel le premier commutateur à semi-conducteur (50) est un transistor bipolaire à grille isolée et le premier commutateur à semi-conducteur (50) a trois premières bornes conductrices (500), les trois premières bornes conductrices (500) servant respectivement de grille, d'émetteur et de collecteur, dans laquelle la première électrode (520) est électriquement connectée au collecteur du premier commutateur à semi-conducteurs (50), la deuxième électrode (521) est électriquement connectée à la grille du premier commutateur à semi-conducteurs (50), et la troisième électrode (522) est électriquement connectée à l'émetteur du premier commutateur à semi-conducteurs (50).

6. Le module d'alimentation selon la revendication 5, dans lequel le premier sous-module (5) comprend en outre
une première couche d'isolation (53), dans laquelle une pluralité de premiers passages conducteurs (530) et un deuxième passage conducteur (531) sont formés dans la première couche d'isolation (53) ;
une première couche conductrice (52) disposée sur une première surface (532) de la première couche isolante (53) et ayant une pluralité de structures de séparation (525), dans laquelle la première couche conductrice (52) est divisée en la deuxième électrode (521), la troisième électrode (522), la quatrième électrode (523) et la première électrode conductrice (524) par la pluralité de structures de séparation (525) ; etune deuxième couche conductrice (52) disposée sur une deuxième surface (532) de la première couche isolante (53) et ayant une pluralité de trous conducteurs (530) et un deuxième trou conducteur traversant (531) formé dans la première couche isolante (53).
une deuxième couche conductrice (54) disposée sur une deuxième surface (533) de la première couche isolante (53), la deuxième couche conductrice (54) étant en contact avec des premières extrémités de la pluralité de premières traversées conductrices (530) et avec une première extrémité de la deuxième traversée conductrice (531).

7. Le module d'alimentation selon la revendication 6, dans lequel le premier commutateur à semi-conducteur (50), la première diode (51) et la première structure conductrice thermique/électrique (55) sont encastrés dans la première couche isolante (53), et la première structure conductrice thermique/électrique (55) a une première face (551) et une deuxième face (552), dans lequel la première borne conductrice (500) sert de grille du premier commutateur à semi-conducteur (50), est reliée électriquement à la deuxième électrode (521), la première borne conductrice (500) servant d'émetteur du premier commutateur à semi-conducteur (50) est reliée électriquement à la troisième électrode (522), et la première borne conductrice (500) servant de collecteur du premier commutateur à semi-conducteur (50) est mise en contact avec les secondes extrémités des premiers vias conducteurs respectifs (530), de manière à être connectée électriquement à la première électrode (520), dans lequel la deuxième borne conductrice (510) servant d'anode de la première diode (51) est connectée électriquement à la quatrième électrode (523), et la deuxième borne conductrice (510) servant de cathode de la première diode (51) est mise en contact avec les deuxièmes extrémités des premières traversées conductrices respectives (530), de manière à être connectée électriquement à la première électrode (520), dans lequel la première surface (551) de la première structure conductrice thermique/électrique (55) est en contact avec la première électrode conductrice (524) et la deuxième surface (552) de la première structure conductrice thermique/électrique (55) est en contact avec une deuxième extrémité de la deuxième via conductrice (531) de manière à être connectée électriquement à la première électrode (520).

8. Le module d'alimentation selon l'une des revendications 1 ou 5-7, dans lequel le deuxième commutateur à semi-conducteurs (60) est un transistor bipolaire à grille isolée et le deuxième commutateur à semi-conducteurs (60) comporte trois troisièmes bornes conductrices (600), les trois troisièmes bornes conductrices (600) étant utilisées comme grille, émetteur ou collecteur, dans lequel la cinquième électrode (620) est connectée électriquement à l'émetteur du deuxième commutateur à semi-conducteurs (60), la sixième électrode (621) est connectée électriquement à la grille du deuxième commutateur à semi-conducteurs (60), et la septième électrode (622) est connectée électriquement au collecteur du deuxième commutateur à semi-conducteurs (60).

9. Le module d'alimentation selon la revendication 8, dans lequel le deuxième sous-module (6) comprend en outre :
une deuxième couche d'isolation (63), dans laquelle une pluralité de troisièmes traversées conductrices (630) et une quatrième traversée conductrice (631) sont formées dans la deuxième couche d'isolation (63) ;
une troisième couche conductrice (62) disposée sur une première surface (632) de la deuxième couche isolante (63) et divisée en une septième électrode (622) et une deuxième électrode de plomb (624) ; et
une quatrième couche conductrice (64) disposée sur une deuxième surface (633) de la deuxième couche isolante (63), la quatrième couche conductrice (64) étant divisée en la cinquième électrode (620) et la sixième électrode (621), la cinquième électrode (620) et la sixième électrode (621) étant en contact avec les premières extrémités de la pluralité de troisièmes traversées conductrices (630), la sixième électrode (621) étant en outre en contact avec une première extrémité de la quatrième traversée conductrice (631).

10. Le module d'alimentation selon la revendication 9, dans lequel le deuxième commutateur à semi-conducteur (60), la deuxième diode (61) et la deuxième structure conductrice thermique/électrique (65) sont encastrés dans la deuxième couche isolante (63), et la deuxième structure conductrice thermique/électrique (65) présente une première face (651) et une deuxième face (652), dans lequel la troisième borne conductrice (600) sert d'émetteur du deuxième commutateur à semi-conducteur (60), est mise en contact avec les deuxièmes extrémités des troisièmes traversées conductrices respectives (630) de manière à être connectée électriquement à la cinquième électrode (620), dans laquelle la troisième borne conductrice (600) servant de grille du deuxième commutateur à semi-conducteur (60) est mise en contact avec la deuxième extrémité de la troisième traversée conductrice respective (630) de manière à être connectée électriquement à la sixième électrode (621), et la troisième borne conductrice (600), qui sert de collecteur du deuxième commutateur à semi-conducteurs (60), est relié électriquement à la septième électrode (622), la quatrième borne conductrice (610) servant d'anode de la deuxième diode (61) étant mise en contact avec les deuxièmes extrémités des troisièmes traversées conductrices respectives (630) de manière à être reliée électriquement à la cinquième électrode (620), et la quatrième borne conductrice (610) servant de cathode de la deuxième diode (61), est connecté électriquement à la septième électrode (622), dans lequel la première surface (651) de la deuxième structure conductrice thermique/électrique (65) est en contact avec la deuxième électrode de plomb (624), et la deuxième surface (652) de la deuxième structure conductrice thermique/électrique (65) est en contact avec une deuxième extrémité du quatrième passage conducteur (631) de manière à être connectée électriquement à la sixième électrode (621).

11. Le module d'alimentation selon l'une quelconque des revendications 1 ou 5-10, dans lequel le quatrième bloc conducteur (713) du substrat (7) est électriquement connecté à la deuxième électrode de plomb (624).

12. Le module d'alimentation selon l'une des revendications 1 ou 5-11, dans lequel la broche conductrice (3) est une broche ou la broche conductrice (3) est sortie du premier bloc conducteur (710).

13. Le module d'alimentation selon l'une des revendications 1 ou 5-12, dans lequel la broche conductrice (3) présente un segment en saillie (331) et la carte de circuit imprimé (2) présente une fente d'insertion (201) correspondant au segment en saillie (331), dans lequel le segment en saillie (331) de la broche conductrice (3) est inséré dans la fente d'insertion (201) de la carte de circuit imprimé (2), dans lequel un premier élément conducteur (20) est disposé sur une seconde surface (25) de la carte de circuit (2) et aligné avec la fente d'insertion (201), dans lequel lorsque le segment en saillie (331) de la broche conductrice (3) est inséré dans la fente d'insertion (201), le premier élément conducteur (20) est électriquement connecté à la fente d'insertion (201), et le premier sous-module (5) et le second sous-module (6) sont séparés de la carte de circuit (2) par un espace.
